# EUROPÄISCHE PATENTSCHRIFT

(11) **EP 3 225 317 B1**
(45) Veröffentlichungstag und Bekanntmachung des Hinweises auf die Patenterteilung: **19.06.2019**
(21) Anmeldenummer: 17158709.0
(22) Anmeldetag: 01.03.2017
(51) Int. Cl.: C23C 16/00, C23C 16/30, B05D 1/00, B05D 5/08

(54) **OBERFLÄCHENBESCHICHTUNG FÜR HOCHWERTIGE WEISS- UND/ODER GRAUWARE**
SURFACE COATING FOR HIGH QUALITY WHITE AND/OR GREY GOODS
REVÊTEMENT DE SURFACE POUR PRODUITS GRIS ET/OU BLANCS DE HAUTE QUALITÉ

(30) Priorität: 31.03.2016 DE 102016205318
(43) Veröffentlichungstag der Anmeldung: 04.10.2017
(73) Patentinhaber: BSH Hausgeräte GmbH, 81739 München (DE)
(72) Erfinder: Eder, Florian, 91052 Erlangen (DE); Jördens, Frank, 83278 Traunstein (DE); Maleika, Marek, 90766 Fürth (DE); Ntourmas, Felix, 91052 Erlangen (DE)

(56) Entgegenhaltungen:
- DE-A1-102005 026 359
- DE-B3-102013 219 337
- DE-U1-202008 009 985

## Beschreibung

Die Erfindung betrifft eine neuartige Oberflächenbeschichtung für hochwertige Weiß-Grau-Ware, also Gegenstände des Haushalts-, Sanitär- und/oder Automotive-Bereichs, insbesondere Gehäuseelemente von entsprechenden Apparaturen und Maschinen sowie Dekor, beispielsweise solche, die gezielt metallische Applikationen und/oder Elemente haben.

Nach dem Vorbild aus der Uhren- und Schmuckbranche werden mittlerweile auch in vielen Branchen des Haushalts-, Sanitär- oder Automotive-Bereichs viele, vor allem höher klassige Produkte, gezielt mit metallischen Elementen, bevorzugt aus Edelstahl oder Aluminium, ausgestattet. Die grundsätzlich metallisch glänzende und häufig zusätzlich polierte, gebürstete und/oder anderweitig strukturierte Oberfläche gilt als modern und erzeugt in der menschlichen Wahrnehmung einen höheren Wert. Diese Oberflächen haben jedoch den Nachteil, dass sie im Kontakt mit ihrer Umgebung sehr anfällig für die Anhaftung von Rückständen, wie z.B. Feuchtigkeit, Staub-, Schweiß-, Fett- und/oder Lebensmittel-Reste, sind, die in den üblichen Einsatzgebieten wie Küchenbereich, Sanitärbereich, Fahrzeug und/oder Flugzeuginnenraum in der Praxis unvermeidlich bei der Bedienung und/oder Benutzung auftreten.

Rückstände dieser Art werden durch das menschliche Bewusstsein sofort negativ als Verschmutzungen identifiziert und werten damit zeitgleich den Hygieneeindruck sowie das optische Erscheinungsbild der Oberfläche deutlich ab. Kritisch ist zudem, dass durch die häufig eingebrachte Oberflächenmikrostruktur eine Abreinigung der Verschmutzungen erschwert ist und je nach Art der Verschmutzung, z.B. organische Säuren, diese auch angegriffen werden kann, was dauerhaft zu einer veränderten Oberflächenzusammensetzung führen kann, die sich negativ auf das äußere Erscheinungsbild auswirken kann.

Zur Vermeidung dieser anhaftenden Rückstände und/oder zur Vermeidung der Beschädigung der Strukturierung der edlen Oberflächen wird bislang auf Beschichtung, teilweise durch Folienbeschichtung, teilweise durch nasschemische Verfahren oder Beschichtungen, die über Gasphasenabscheidungsprozesse (PVD, CVD) herstellbar sind, gesetzt. Diese auf die betroffenen Oberflächen aufgebrachten Folien- und/oder Schichtsysteme sind nach dem Stand der Technik soweit erforscht, dass sie durch eine gezielte chemische Zusammensetzung sowohl die erforderlichen abweisenden Eigenschaften also Hydrophobie, Oleophobie und/oder Leichtreinigbarkeit zeigen.

Ein Nachteil an diesen bisherigen technischen Lösungen besteht darin, dass die Folien- oder Schichtaufbringung das äußere Erscheinungsbild und die Haptik der Oberfläche durch die Modifikation in der Regel negativ beeinflusst werden. So verliert die metallische Oberfläche in der menschlichen Wahrnehmung vor allem bei den Folien- und Dickschichtsystemen sowohl optisch also bezüglich der Metallfarbe, des metallischen Glanzes, also auch haptisch beispielsweise beim Strukturempfinden ihren ursprünglich wertvermittelnden Charakter.

Die DE 10 2003 219 337 B3, DE 10 2005 026 359 und DE 20 2008 009 985 U1 zeigen auch Oberflächenbeschichtungen, wobei DE 10 2005 026 359 A ein Verfahren zur Herstellung einer die Schmutzwahrnehmung unterdrückenden Oberfläche offenbart.

Aufgabe der vorliegenden Erfindung ist es daher, eine Oberflächengestaltung für edle, sprich metallische, metallisierte und/oder strukturierte Oberflächen von Fahrzeug und/oder Flugzeuginnenräumen, sowie Weiß- und Grau-Ware zur Verfügung zu stellen, die Rückstände, die durch Gebrauch entstehen, möglichst unsichtbar macht und/oder eine Abreinigung erleichtert.

Diese Aufgabe wird durch den Gegenstand von Anspruch 1 gelöst. Bevorzugte Ausführungsformen sind in den Ansprüchen 2 bis 7 definiert.

Entsprechend ist Gegenstand der vorliegenden Erfindung eine Oberflächenbeschichtung auf einer strukturierten metallischen oder metallisierten Oberfläche, dadurch gekennzeichnet, dass die Oberflächenbeschichtung hydrophobe und/oder oleophobe Eigenschaften zeigt und die Dicke der Oberflächenbeschichtung geringer als die Strukturtiefe der Oberflächenstruktur ist.

Als Oberflächenstruktur wird eine übliche, für edle Oberflächen gängige Strukturierung von metallischen oder metallisierten Oberflächen wie Bürsten, Schleifen, Prägen, Ätzen, etc. bezeichnet. Als Strukturtiefe wird die Rauigkeit der Oberflächenstruktur, gemessen in Ra (Rauigkeit, durchschnittlich, also average), bezeichnet, also die Länge von einem Strukturtal zu einem Strukturberg auf der strukturierten Oberfläche ohne Oberflächenbeschichtung.

Die Terme "hydrophob" und "oleophob" bezeichnen Oberflächeneigenschaften die im einen Fall Wasserabweisend, also hydrophob sind und im anderen Fall Fett- oder Ölabweisend, also oleophob sind.

Als Dicke der Oberflächenbeschichtung wird die Ausdehnung der Beschichtung quer zur beschichteten Oberfläche verstanden.

Der neuartige Ansatz basiert auf der Ausnutzung eines bislang nicht bekannten Synergieeffekts, der sich aus der in der Praxis gezielt eingebrachten Struktur, insbesondere einer Mikrostruktur der betroffenen Oberfläche - beispielsweise gebürstetes und/oder geschliffenes Edelstahl und/oder Aluminium - und einer darauf aufgebrachten, dünnen Funktionsschicht, die entweder hydrophob und/oder oleophob wirkt, ergibt.

So haben Versuche mit einer Oberflächenbeschichtung nach der Erfindung an Oberflächen von Serienteilen mit einer geschliffenen Edelstahlstruktur gezeigt, dass in der Wechselwirkung mit fettabgebenden Kontaktpartnern, z.B. Vaseline-Stempel und/oder Finger, im zeitlichen Verlauf - Minutenmaßstab - ein
Oberflächeneffekt eintritt, der zu einem Verfließen der lokal hinterlassenen Rückstände führt. Das Verfließen der Rückstände findet vorzugsweise in Richtung der vorhandenen Oberflächenstruktur, beispielsweise einem Längsschliff, statt und ist dahingehend auf eine Art intrinsischen Kapillar- und/oder Kanaleffekt der Schliffstruktur zurückzuführen. Vorteilhaft ist dabei, dass das Verfließen mit einer starken Reduzierung der lokalen Verschmutzungsintensität einhergeht.

Die Rückstandsmenge verteilt sich dabei im zeitlichen Verlauf auf eine größere Fläche, wodurch infolge der Reduzierung der Verschmutzungsausprägung in Dickenrichtung der Kontrast von der verschmutzten Stelle gegenüber der nicht verschmutzten immer schwächer wird, also eine Kontrastabschwächung gegenüber dem Hintergrund, erzielt wird. Durch den Verfließ-Effekt werden die Rückstände immer weniger erkennbar für das menschliche Auge.

Dieser überraschende Effekt wird nun mit den bereits bekannten Schichtsystemen in Kombination gebracht, wobei für die Aufrechterhalten dieses Effekts vor allem eine möglichst dünne Oberflächenbeschichtung, also eine Schicht im Nanometerbereich vorteilhaft ist.

Dies ist insbesondere auch deshalb vorteilhaft, weil eine nur wenige Nanometer - also beispielsweise unter 100 nm - dicke Schicht hier schon den Verfließeffekt zeigt, aber die Oberfläche der Ware ansonsten, hinsichtlich des metallischen Glanzes und/oder hinsichtlich der Haptik natürlich weit weniger verändert als eine dickere Oberflächenbeschichtung, beispielsweise eine Oberflächenbeschichtung im Mikrometerbereich.

Insbesondere haben sich hier Oberflächenbeschichtungen mit Antifingerprint-Eigenschaften, die beispielsweise durch Plasmabeschichtung, insbesondere durch Atmosphärendruckplasma aufbringbar sind, als günstig erwiesen. Andere Beschichtungsverfahren, wie beispielsweise die Coilbeschichtung können ebenso zur Herstellung einer Oberflächenbeschichtung nach der Erfindung alternativ oder ergänzend eingesetzt werden.

Als Antifingerprint werden bei Oberflächenbeschichtungen Eigenschaften bezeichnet, die beispielsweise dünne anorganisch-organische Hybridbeschichtungen, die auf metallischen oder metallisierten Oberflächen Spuren, also Sichtbarkeit von Fingerabdrücken verhindern. Sie bilden eine gewisse Barriere gegen die in Fingerabdrücken vorhandenen fettähnlichen organischen Säuren und auch gegen die anorganischen Salze aus dem Fingerfett. Sie vermindern die Anhaftung einerseits und unterdrücken andererseits die Sichtbarkeit der Restanhaftung. Eine Entfernung der Restverschmutzung wird deutlich erleichtert.

Die Schichtdicke der Oberflächenbeschichtung liegt im Bereich unter 400 nm, bevorzugt unter 200 nm, noch bevorzugter unter 100nm und insbesondere bei Schichtdicken kleiner 60nm.

Um die Sichtbarkeit der auch verfließenden Rückstände weiter zu erniedrigen wird vorgeschlagen, eine Oberflächenbeschichtung, deren Brechungsindex im Bereich zwischen 1,4 und 1,5 liegt, insbesondere bewährt hat sich für die Unsichtbarkeit der häufigsten Rückstände eine Einstellung des Brechungsindexes der Oberflächenbeschichtung im Bereich von 1,42 bis 1,46.

Nach einer weiteren vorteilhaften Ausführungsform der Erfindung wird eine Oberflächenbeschichtung so gewählt, dass sie eine niedrige Oberflächenenergie von 10 bis 30 mN/m aufweist, insbesondere bevorzugt einen Oberflächenenergie von 15 bis 20 mN/m.

Die Substrate sind metallische oder metallisiert und weisen eine Oberflächenstruktur auf, deren Rauigkeit im Bereich von Ra = 5 - 100 µm, bevorzugt Ra = 5 bis 20 µm liegt.

Zur Einstellung des Brechungsindexes, also die optische Dichte der Oberflächenbeschichtung können die üblichen aus der Praxis der Plasmabeschichtung, insbesondere der Atmosphärenplasmabeschichtung, bekannten Methoden angewendet werden. Beispielsweise können hybrid-organische Precursoren, die Kohlenstoffhaltig sind, hier eingesetzt werden, um den richtigen Brechungsindex zu erhalten.

Als Precursoren für die - beispielsweise - hydrophobe Beschichtung sei stellvertretend HADS Hexaalkyldisiloxan, das beispielsweise in Form seines Methyl-Derivates nach der Plasmabeschichtung einen dünnen Film mit einer hohen Anzahl an hydrophobierend wirkenden Alkylgruppen an der Oberfläche ausbildet, genannt. Eine Hydrophobierung durch eine Oberflächenbeschichtung bewirkt grundsätzlich, dass die üblichen, oben genannten, Rückstände abgestoßen werden.

Durch einen teilweise Entfernung der in den Precursormolekülen vorhandenen Alkylgruppen sowie durch eine mehr oder weniger vollständig ablaufende Vernetzungsreaktion der angeregten Precursormoleküle wird die Oberflächenenergie der Beschichtung eingestellt, so dass eine polarere Oberfläche, von der fettige oder ölige Rückstände abgestoßen werden, entsteht.

Durch die vorliegende Erfindung wird erstmals ein Zusammenhang zwischen einer Oberflächenstrukturierung und der Oberflächenbeschichtung einer edlen metallischen oder metallisierten Oberfläche hergestellt, derart, dass die Höhe Oberflächenrauigkeit der Oberflächenstrukturierung die Dicke der Oberflächenbeschichtung um ein Vielfaches überragt, damit die Oberflächenstrukturierung auf eine Art intrinsischen Kapillar-/ Kanaleffekt ein Verfließen unerwünschter Rückstände begünstigt. Durch das Verfließen wird die Kontur der Verschmutzung verwischt bis sie schließlich gänzlich unkennbar wird.

## Patentansprüche

1. Oberflächenbeschichtung auf einer strukturierten metallischen oder metallisierten Oberfläche, **dadurch gekennzeichnet, dass** die Oberflächenbeschichtung hydrophobe und/oder oleophobe Eigenschaften zeigt und die Dicke der Oberflächenbeschichtung geringer als die Strukturtiefe der Oberflächenstruktur genannten strukturierten metallischen oder metallisierten Oberfläche ist, wobei die Strukturtiefe die Rauigkeit der Oberflächenstruktur ist, und im Bereich Ra = 5 bis 100 µm liegt.

2. Oberflächenbeschichtung nach Anspruch 1, wobei die Dicke der Oberflächenbeschichtung ungefähr um einen Faktor 10 kleiner als die Rauigkeit der Oberflächenstruktur ist.

3. Oberflächenbeschichtung nach einem der vorstehenden Ansprüche, die Antifingerprint-Eigenschaften aufweist, wobei die Oberflächenbeschichtung eine anorganisch-organische Hybridbeschichtung ist.

4. Oberflächenbeschichtung nach einem der vorstehenden Ansprüche, wobei die Dicke der Oberflächenbeschichtung unter 400 nm liegt.

5. Oberflächenbeschichtung nach einem der vorstehenden Ansprüche, deren Brechungsindex im Bereich zwischen 1,4 und 1,5 liegt.

6. Oberflächenbeschichtung nach einem der vorstehenden Ansprüche, deren Oberflächenenergie im Bereich von 10 bis 30 mN/m liegt.

7. Oberflächenbeschichtung auf einem metallischen oder metallisierten Substrat mit Oberflächenstruktur nach einem der vorstehenden Ansprüche, wobei die Rauigkeit der Oberflächenstruktur im Bereich von Ra = 5 bis 20 µm, liegt.

## Claims

1. Surface coating on a structured metallic or metallised surface, **characterised in that** the surface coating exhibits hydrophobic and/or oleophobic properties and the thickness of the surface coating is smaller than the structure depth of the structured metallic or metallised surface, which is referred to as surface structure, wherein the structure depth is the roughness of the surface structure, and lies in the range of Ra = 5 to 100 µm.

2. Surface coating according to claim 1, wherein the thickness of the surface coating is less than the roughness of the surface structure approximately by a factor 10.

3. Surface coating according to one of the preceding claims, which has anti-fingerprint properties, wherein the surface coating is an inorganic-organic hybrid coating.

4. Surface coating according to one of the preceding claims, wherein the thickness of the surface coating lies below 400 nm.

5. Surface coating according to one of the preceding claims, the refraction index of which lies in the range between 1.4 and 1.5.

6. Surface coating according to one of the preceding claims, the surface energy of which lies in the range of 10 to 30 mN/m.

7. Surface coating on a metallic or metallised substrate with surface structure according to one of the preceding claims, wherein the roughness of the surface structure lies in the range of Ra = 5 to 20 µm.

## Revendications

1. Revêtement de surface sur une surface métallique ou métallisée structurée, **caractérisé en ce que** le revêtement de surface présente des propriétés hydrophobes et/ou oléophobes et **en ce que** l'épaisseur du revêtement de surface est inférieure à la profondeur de structure de la structure superficielle de ladite surface métallique ou métallisée structurée, dans lequel la profondeur de structure est la rugosité Ra de la structure superficielle, qui est de 5 à 100 µm.

2. Revêtement de surface selon la revendication 1, dans lequel l'épaisseur du revêtement de surface est environ 10 fois plus petite que la rugosité de la structure superficielle.

3. Revêtement de surface selon l'une des revendications précédentes, qui présente des propriétés anti-empreintes digitales, dans lequel le revêtement de surface est un revêtement hybride inorganique-organique.

4. Revêtement de surface selon l'une des revendications précédentes, dans lequel l'épaisseur du revêtement de surface est inférieure à 400 nm.

5. Revêtement de surface selon l'une des revendications précédentes, dont l'indice de réfraction est de 1,4 à 1,5.

6. Revêtement de surface selon l'une des revendications précédentes, dont l'énergie de surface est de 10 à 30 mN/m.

7. Revêtement de surface selon l'une des revendications précédentes sur un substrat métallique ou métallisé possédant une structure superficielle, dans lequel la rugosité Ra de la structure superficielle est de 5 à 20 µm.
